# EUROPEAN PATENT APPLICATION

(11) **EP 3 133 654 A1**
(43) Date of publication of application: **22.02.2017**
(21) Application number: 15779909.9
(22) Date of filing: 07.04.2015
(51) Int. Cl.: H01L 41/193, D03D 1/00, D03D 15/00, G01L 1/16, H01L 41/09, H01L 41/113, H01L 41/45, H02N 2/18

(54) **TRANSDUCER WHICH USES FIBERS AND USES ELECTRIC SIGNAL AS OUTPUT OR INPUT**

(30) Priority: 16.04.2014 JP 2014084392; 16.04.2014 JP 2014084400; 07.01.2015 JP 2015001562
(71) Applicant: Teijin Limited, Osaka-shi, Osaka 541-0054 (JP); Kansai University, Suita-shi, Osaka 564-0073 (JP)
(72) Inventor: TAJITSU, Yoshiro, Suita-shi Osaka 564-0073 (JP); ONO, Yuhei, Osaka-shi Osaka 541-0054 (JP); UCHIYAMA, Akihiko, Osaka-shi Osaka 541-0054 (JP); YAMAMOTO, Tomoyoshi, Osaka-shi Osaka 541-0054 (JP)
(74) Representative: Carpmaels & Ransford LLP
(86) International application number: PCT/JP2015/061301
(87) International publication number: WO 2015/159832

(57) **Abstract**

A transducer in the form of cloth having high flexibility obtained by manufacturing a conventional woven or knitted fabric structure using general-purpose fiber materials.

The transducer includes piezoelectric units, each including two conductive fibers and one piezoelectric fiber arranged substantially on the same plane in the order of the conductive fiber, the piezoelectric fiber and the conductive fiber, and outputs and inputs an electric signal.

## Description

### TECHNICAL FIELD

The present invention relates to a transducer which outputs an electric signal by its form change caused by external force. Further, the present invention relates to a transducer which changes its form by the input of an electric signal. Still further, the present invention relates to a transducer in the form of cloth which can change its form flexibly and three-dimensionally.

### BACKGROUND ART

In recent years, so-called "wearable sensors" have been attracting attention, and commercial products in the form of eyeglasses and wristwatches have been put on the market. However, these devices make users feel like these devices are attached to their bodies, and an ultimate wearable sensor in the form of cloth, that is, clothing is desired. A sensor including a piezoelectric element attached to cloth from which a signal is extracted is disclosed as the above sensor (Patent Document 1) . Although there is a structure in the form of cloth obtained by combining piezoelectric material and conductive material films, fibrous materials having a special structure must be used (Patent Document 2). There is "hitoe" announced by Nippon Telegraph and Telephone Corporation (NTT) and Toray Industries, Inc. in January 30, 2014, which detects a muscle potential with a conductive fiber in close contact with the body and does not output an electric signal by its form change.

Meanwhile, there is proposed an actuator in the form of a film comprising polylactic acid (Patent Document 3). However, this film can be bent only in one direction and has poor stretchability and flexibility. Therefore, it is far from flexible. Further, the method of producing this actuator requires several stages for processing the film.
(Patent Document 1) JP-A 2007-518886
(Patent Document 2) JP-A 2002-203996
(Patent Document 3) JP-A 2013-251363

### DISCLOSURE OF THE INVENTION

It is an object of the present invention to provide a transducer in the form of cloth which is flexible and has a woven or knitted fabric composed of ordinary fiber materials. It is another object of the present invention to provide a sensor or a power generating element which uses a signal from the transducer. It is still another object of the present invention to provide an actuator or a speaker which functions by the input of an electric signal into the transducer.

The inventors of the present invention found that a combination of two conductive fibers and one piezoelectric fiber may function as a transducer. The present invention was accomplished based on this finding. They also found that a transducer including fibers obtained by coating a synthetic fiber with an electric conductor as the conductive fibers has high strength in a normal direction with respect to the fiber axis and excellent durability when it is used for a long time.

That is, the present invention includes the following inventions.
1. A transducer including piezoelectric units, each comprising two conductive fibers and one piezoelectric fiber all of which are arranged substantially on the same plane in the order of the conductive fiber, the piezoelectric fiber and the conductive fiber, and outputting and inputting an electric signal.
2. The transducer in the above paragraph 1, wherein the piezoelectric unit comprises an insulating fiber which is arranged to ensure that the conductive fibers in the piezoelectric unit do not come into contact with the conductive fibers or the conductive fibers and the piezoelectric fiber of another piezoelectric unit.
3. The transducer in the above paragraph 1, wherein the piezoelectric fiber comprises polylactic acid as the main component.
4. The transducer in the above paragraph 1, wherein the piezoelectric fiber comprises poly-L-lactic acid or poly-D-lactic acid as the main component, and the optical purities of these are not less than 99 %.
5. The transducer in the above paragraph 1, wherein the piezoelectric fiber is uniaxially oriented and contains a crystal.
6. The transducer in the above paragraph 1, wherein the conductive fiber is a fiber obtained by coating (i) a carbon fiber or (ii) a synthetic fiber with an electric conductor.
7. The transducer in the above paragraph 1 which has a detection voltage after the conductive fiber is folded in a normal direction 2,000 times repeatedly of not less than 90 % of that before folding.
8. The transducer in the above paragraph 1 which is a woven or knitted fabric comprising a plurality of piezoelectric units.
9. The transducer in the above paragraph 8 which is a woven fabric comprising a plurality of piezoelectric units and whose weave texture is plain weave, twill weave, satin weave or composite texture thereof.
10. The transducer in the above paragraph 8 which is a combination of at least two fabrics selected from the group consisting of knitted fabrics and woven fabrics.
11. A sensor comprising the transducer of any one of the above paragraphs 1 to 10.
12. A power generating element comprising the transducer of any one of the above paragraphs 1 to 10.
13. An actuator comprising the transducer of any one of the above paragraphs 1 to 10.
14. A speaker comprising the transducer of any one of the above paragraphs 1 to 10.

### BRIEF DESCRIPTION OF THE DRAWINGS

Fig. 1 is a schematic diagram of the plain woven fabric of Example 1;
Fig. 2 is a schematic diagram of the satin woven fabric of Example 1;
Fig. 3 shows the appearance of the arm sensor of Example 1;
Fig. 4 shows an electric signal which is output when the arm sensor of Example 1 is attached to an arm and the arm is bent;
Fig. 5 shows an electric signal which is output when the arm sensor of Example 1 is attached to an arm and the arm is stretched;
Fig. 6 shows an electric signal which is output when the arm sensor of Example 1 is attached to an arm and the arm is twisted inward;
Fig. 7 shows an electric signal which is output when the arm sensor of Example 1 is attached to the arm and the arm is twisted outward;
Fig. 8 is a schematic diagram of the plain woven fabric of Example 8;
Fig. 9 is a schematic diagram of the piezoelectric element (transducer) of Example 3;
Fig. 10 is a schematic diagram of the piezoelectric element (transducer) of Example 4;
Fig. 11 is a schematic diagram of the piezoelectric element (transducer) of Example 5;
Fig. 12 is a schematic diagram of the piezoelectric element (transducer) of Example 6;
Fig. 13 is a schematic diagram of the piezoelectric element (transducer) of Example 8 which is an example of the piezoelectric element of another embodiment 1;
Fig. 14 is a schematic diagram of an evaluation system for the piezoelectric elements of Examples 7 and 8;
Fig. 15 is a schematic diagram of the piezoelectric element (transducer) of Example 9 which is an example of the piezoelectric element of still another embodiment 2; and
Fig. 16 is a schematic diagram of an evaluation system for the piezoelectric element (transducer) of Example 9.

### Explanation of reference symbols

- 1: piezoelectric polymer
- 2: conductive fiber
- 3: piezoelectric element fixing plate
- 4: evaluation wiring
- 5: oscilloscope
- 11: piezoelectric polymer
- 12: conductive fiber
- 13: surface conductive layer
- 21: oscilloscope
- 22: evaluation wiring
- 23: evaluation wiring
- 24: conductive fiber
- 25: metal electrode
- 26: piezoelectric polymer
- 27: surface conductive layer
- A: piezoelectric fiber
- B: conductive fiber
- C: insulating fiber

### BEST MODE FOR CARRYING OUT THE INVENTION

The present invention is attained by a transducer including piezoelectric units, each including two conductive fibers and one piezoelectric fiber which are arranged substantially on the same plane in the order of the conductive fiber, the piezoelectric fiber and the conductive fiber, and outputting and inputting an electric signal. A part including a plurality of piezoelectric units may be referred to as "piezoelectric element". The transducer includes a piezoelectric element and wiring for outputting and inputting an electric signal. A description is subsequently given of each of the above constituent components.

### (conductive fiber)

The diameter of the conductive fiber is preferably 1 µm to 10 mm, more preferably 10 µm to 5 mm, much more preferably 0.1 to 2 mm. When the diameter is small, strength degrades and handling becomes difficult. When the diameter is large, flexibility is sacrificed. The cross-sectional shape of the conductive fiber is preferably circular or elliptic from the viewpoints of the design and production of the piezoelectric element but not limited to these.

To extract an electric output from a piezoelectric polymer efficiently, the electric resistance of the conductive fiber is preferably low, i.e., preferably not more than 10⁻¹ Ω·cm, more preferably not more than 10⁻² Ω·cm, much more preferably not more than 10⁻³ Ω·cm in terms of volume resistivity.

Any material may be used as the material of the conductive fiber if it exhibits conductivity. A conductive polymer is preferred as it needs to be formed fibrous. As the conductive polymer may be used polyaniline, polyacetylene, poly(p-phenylene vinylene), polypyrrole, polythiophene, poly(p-phenylene sulfide) and carbon fiber.

From the viewpoints of flexibility and the stability of electric properties in the longitudinal direction, a carbon fiber is preferred. An ordinary carbon fiber is generally a multifilament which is a bundle of filaments. This multifilament may be used, or a monofilament may be used. Use of the multifilament is preferred from the viewpoint of the stability of electric properties in the longitudinal direction. The diameter of the monofilament is 1 to 5,000 µm, preferably 2 to 100 µm, more preferably 3 to 10 µm. The number of filaments is preferably 10 to 100,000, more preferably 100 to 50, 000, much more preferably 500 to 30, 000. The carbon fiber has an advantage that it has high strength in the fiber axis direction.

A conductive fiber comprising a polymer as a matrix and a fibrous or granular conductive filler may be used.

Further, a conductive fiber including a layer having conductivity on the surface of the fiber may also be used. The layer having conductivity may be formed by coating a known conductive polymer or a fibrous or granular conductive filler. The base fiber (fiber to be coated with an electric conductor) of the conductive fiber is preferably a natural fiber, semi-natural fiber or synthetic fiber for improving durability. The conductive fiber having the conductive layer on the surface of the fiber has high strength in the normal direction with respect to the fiber axis and excellent durability when it is used for a long time as compared with carbon fibers.

Examples of the base fiber of the conductive fiber include natural fibers such as cotton, hemp and silk, semi-synthetic fibers such as rayon, cupra, triacetate and diacetate, polyester-based fibers and copolymer fibers thereof such as polyethylene terephthalate, polyethylene naphthalate, polylactic acid, polyglycolic acid and polybutylene succinate, polyamide-based fibers and copolymer fibers thereof such as nylon 6, nylon 66, nylon 46, nylon 410, nylon 610, nylon 10, nylon 11, nylon 12, nylon 6T, nylon 8T and nylon 10T, polyolefin-based fibers such as polyethylene and polypropylene, polyphenylene sulfide fibers, polycarbonate fibers, aramid fibers and other synthetic fibers. A composite fiber of two or more of these may also be used. A synthetic fiber is preferably used as the base fiber from the viewpoints of handling property and durability.

Any electric conductor may be used as the electric conductor to be coated on the surface of the base fiber as long as it exhibits conductivity and the effect of the present invention is obtained.

For example, gold, silver, platinum, copper, nickel, tin, zinc, palladium, copper, indium tin oxide and mixtures and alloys thereof may be used. The coating method and means are not limited. The present invention can be widely applied to fibers obtained by applying paste containing a metal and to fibers coated with an electric conductor by electroplating, chemical plating or vacuum vapor deposition.

Conductive polymers such as polyaniline, polyacetylene, poly(p-phenylene vinylene), polypyrrole, polythiophene and poly (p-phenylene sulfide) may also be used as the electric conductor. These electric conductors may be used in combination of two or more.

The conductive fiber is a multifilament which is a bundle of filaments. This multifilament may be used, or a monofilament may be used. Use of the multifilament is preferred from the viewpoint of the stability of electric properties in the longitudinal direction. The diameter of the monofilament is preferably 1 to 5,000 µm, more preferably 2 to 100 µm, much more preferably 3 to 10 µm. The number of filaments is preferably 10 to 100,000, more preferably 100 to 50,000, much more preferably 500 to 30,000.

### (piezoelectric fiber)

The piezoelectric fiber is a fiber having piezoelectricity. The piezoelectric fiber is preferably composed of a piezoelectric polymer. Although any polymer which exhibits piezoelectricity, such as polyvinylidene fluoride or polylactic acid, may be used as the piezoelectric polymer, it preferably comprises polylactic acid as the main component. Polylactic acid is easily oriented by drawing after melt spinning to exhibit piezoelectricity and excellent in productivity as it does not require an electric field orientation treatment which is required for polyvinylidene fluoride. Further, since the piezoelectric fiber comprising polylactic acid has small polarization with tension or compression stress in the axis direction, it is difficult to make it function as a piezoelectric element. However, this is preferred for the piezoelectric element of the present invention having a constituent body which readily applies shearing stress to the piezoelectric polymer since it obtains a relatively large electric output with the shearing stress.

The piezoelectric polymer preferably comprises polylactic acid as the main component. The expression "as the main component" means that the content of polylactic acid is preferably not less than 90 mol%, more preferably not less than 95 mol%, much more preferably not less than 98 mol%.

An example of the polylactic acid is poly-L-lactic acid obtained by polymerizing L-lactic acid or L-lactide according to the crystal structure. Another example of the polylactic acid is poly-D-lactic acid obtained by polymerizing D-lactic acid or D-lactide. Still another example is stereocomplex polylactic acid having the hybrid structure of poly-L-lactic acid and poly-D-lactic acid. Any polylactic acid is acceptable if it exhibits piezoelectricity. Poly-L-lactic acid and poly-D-lactic acid are preferred as they have a high piezoelectric modulus. Since the polarizations of poly-L-lactic acid and poly-D-lactic acid are opposite to each other with the same stress, it is possible to use a combination of these according to purpose.

The optical purity of the polylactic acid is preferably not less than 99 %, more preferably not less than 99.3 %, much more preferably not less than 99.5 %. When the optical purity is lower than 99 %, the piezoelectric modulus may significantly drop, thereby making it difficult to obtain a sufficiently high electric output with rubbing force to the surface of the piezoelectric element. Preferably, the piezoelectric polymer comprises poly-L-lactic acid or poly-D-lactic acid as the main component, and the optical purities of these components are not less than 99 %.

Preferably, the piezoelectric polymer is uniaxially oriented in the fiber axis direction of the coated fiber and contains a crystal. More preferably, it is uniaxially oriented polylactic acid having a crystal. This is because the polylactic acid exhibits great piezoelectricity when it is crystalline and uniaxially oriented.

Since polylactic acid is a polyester which is hydrolyzed relatively quickly, when it has a problem with moist heat resistance, a known hydrolysis inhibitor such as isocyanate compound, oxazoline compound, epoxy compound or carbodiimide compound may be added. An antioxidant such as a phosphoric acid-based compound, plasticizer and optical degradation inhibitor may be added as required to improve physical properties.

Further, the polylactic acid may be used in combination with another polymer as an alloy. When the polylactic acid is used as the main piezoelectric polymer, it is contained in an amount of preferably at least 50 wt%, more preferably at least 70 wt%, most preferably at least 90 wt% based on the total weight of the alloy.

In the case of a polylactic acid alloy, preferred examples of a polymer other than polylactic acid include polybutylene terephthalate, polyethylene terephthalate, polyethylene naphthalate copolymer and polymethacrylate. However, the polymer is not limited to these and any polymer may be used as long as a piezoelectric effect which is the object of the present invention is obtained.

The piezoelectric fiber is generally a multifilament which is a bundle of filaments. This multifilament may be used, or a monofilament may be used. Use of the multifilament is preferred from the viewpoint of the stability of piezoelectric characteristics in the longitudinal direction. The diameter of the monofilament is preferably 1 to 5,000 µm, more preferably 5 to 500 µm. It is much more preferably 10 to 100 µm. The number of filaments is preferably 1 to 100,000, more preferably 10 to 50,000, much more preferably 100 to 10,000.

In order to produce a piezoelectric fiber from this piezoelectric polymer, any known technique for fiberizing a polymer may be employed as long as the effect of the present invention is obtained. Examples of the technique include one in which a piezoelectric polymer is extrusion molded to be fiberized, one in which a piezoelectric polymer is melt spun to be fiberized, one in which a piezoelectric polymer is fiberized by dry or wet spinning, and one in which a piezoelectric polymer is fiberized by electrostatic spinning. As for spinning conditions for these techniques, a known technique may be used according to the piezoelectric polymer in use, and a melt spinning technique which facilitates industrial-scale production may be generally employed.

As described above, when the piezoelectric polymer is polylactic acid, the polylactic acid exhibits great piezoelectricity if it is uniaxially oriented and contains a crystal. Therefore, its fiber is preferably drawn.

### (substantially on the same plane)

In the present invention, two conductive fibers and one piezoelectric fiber are arranged substantially on the same plane. The expression "substantially on the same plane" means that the fiber axes of the three fibers are arranged substantially on the plane. The word "substantially" means that this includes a case where the intersections between the fibers become thick.

For example, when one piezoelectric fiber is arranged parallel to two parallel conductive fibers between the conductive fibers, they are existent substantially on the same plane. Even when the fiber axis of one piezoelectric fiber is inclined so that it is not parallel to two parallel conductive fibers, they are substantially on the same plane. Further, even when one conductive fiber and one piezoelectric fiber are arranged parallel to each other and the other conductive fiber is arranged to intersect the conductive fiber and the piezoelectric fiber, they are substantially on the same plane.

When they are arranged substantially on the same plane, a fibrous or cloth piezoelectric element is easily formed by combining the piezoelectric units, and the degree of freedom in the design of the form of a transducer can be increased by using the fibrous or cloth piezoelectric element. The relationship between the piezoelectric fiber and the conductive fibers is suitably selected according to a form change to be detected.

### (arrangement order)

In the piezoelectric unit, preferably, the conductive fiber, the piezoelectric fiber and the conductive fiber are arranged in this order. When they are arranged in this order, the two conductive fibers of the piezoelectric unit are not in contact with each other, thereby making it possible to make the piezoelectric unit function effectively without using a technique for covering the conductive fibers with another means, for example, an insulating material.

At this point, it is desired that the two conductive fibers should have contact points with the one piezoelectric fiber. However, they may not have contact points if the distance between them is not more than 4 mm. The distance between the conductive fiber and the piezoelectric fiber is preferably not more than 3 mm, more preferably not more than 2 mm, much more preferably not more than 1 mm, most preferably not more than 0.5 mm. When the distance is larger than 4 mm, an electric output becomes small due to the form change of the piezoelectric fiber, thereby making it difficult to use the piezoelectric element as a transducer.

As for configuration, the conductive fiber, the piezoelectric fiber and the conductive fiber are arranged substantially parallel to one another in this order. Or, two conductive fibers are arranged parallel to each other, and one piezoelectric fiber is arranged to intersect the two conductive fibers. Further, two conductive fibers may be arranged as warps (or wefts) and one piezoelectric fiber may be arranged as a weft (or warp). In this case, it is preferred that the two conductive fibers should not be in contact with each other. It is preferred that an insulating material, e.g., an insulating fiber should be interposed between the two conductive fibers. An insulating material is coated only on a surface which is apt to be in contact with the conductive fiber, and the conductive fiber should be in direct contact with the piezoelectric fiber.

### (insulating fiber)

In the present invention, the piezoelectric unit includes an insulating fiber which may be arranged between the conductive fiber and the piezoelectric fiber to ensure that the conductive fiber in the piezoelectric unit does not come into contact with the other conductive fiber and the piezoelectric fiber. A fiber composed of a flexible material and having a flexible form may be used as the insulating fiber to improve the flexibility of the cloth. Further, the insulating fiber may be arranged to ensure that the conductive fibers in the piezoelectric unit do not come into contact with the conductive fibers and the piezoelectric fiber of another piezoelectric unit. Since the arrangement order of the present invention is generally (conductive fiber/piezoelectric fiber/conductive fiber), the insulating fiber is arranged in the order of (insulating fiber/conductive fiber/piezoelectric fiber/conductive fiber) or (insulating fiber/conductive fiber/piezoelectric fiber/conductive fiber/insulating fiber). A fiber composed of a flexible material and having a flexible form may be used as the insulating fiber to improve the flexibility of the cloth.

By arranging the insulating fiber in the piezoelectric unit as described above, even when a plurality of piezoelectric units are used in combination, the conductive fibers are not in contact with each other, thereby making it possible to improve the performance of the transducer.

An insulating fiber having a volume resistivity of not less than 10⁶ Ω·cm, preferably not less than 10⁸ Ω·cm, more preferably not less than 10¹⁰ Ω·cm may be used as the insulating fiber.

Examples of the insulating fiber include polyester fibers, nylon fibers, acrylic fibers, polyethylene fibers, polypropylene fibers, vinyl chloride fibers, aramid fibers, polysulfone fibers, polyether fibers and polyurethane fibers. Natural fibers such as silk, semi-synthetic fibers such as acetate and reclaimed fibers such as rayon and cupra may also be used. The insulating fiber is not limited to these, and any known insulating fibers may be used. Further, these insulating fibers may be used in combination, and a combination of the insulating fiber and another non-insulating fiber may be used as long as it has insulating properties as a whole.

To provide flexibility to the cloth, known fibers in any form may also be used.

### (combination of piezoelectric units)

The transducer of the present invention is preferably a woven or knitted fabric comprising a plurality of parallel piezoelectric units. This configuration makes it possible to improve the degree of freedom (flexibility) of changing the form of the piezoelectric element.

There are no limitations to the form of this woven or knitted fabric as long as the woven or knitted fabric includes a plurality of piezoelectric units and functions as a piezoelectric element. To obtain a woven or knitted form, an ordinary weaving machine or knitting machine may be used.

Examples of the weave texture of the woven fabric include three foundation weaves such as plain weave, twill weave and satin weave, derivative weave, double texture structure exchanging the front structure and the back structure such as warp backed weave and weft backed weave, and velvet.

The knitted fabric may be a circular knitted fabric (weft knitted fabric) or warp knitted fabric. Preferred examples of the texture of the circular knitted fabric (weft knitted fabric) include plain stitch, rib stitch, interlock stitch, purl stitch, tuck stitch, float stitch, half cardigan stitch, lace stitch and plating stitch. Examples of the texture of the warp knitted fabric include single Denbigh stitch, single atlas stitch, double cord stitch, half tricot stitch, fleeced stitch and jacquard stitch. The number of layers may be one or two or more. Further, the fabric may be a napped woven fabric or napped knitted fabric comprising a napped part composed of cut piles and/or loop piles and a ground structure part.

Although a bent part is existent in the piezoelectric fiber itself when the piezoelectric units are incorporated in a weave texture or knit texture, to develop the piezoelectric performance of the piezoelectric element efficiently, the bent part of the piezoelectric fiber is preferably small. Therefore, a woven fabric is more preferred than a knitted fabric.

Even in this case, as described above, piezoelectric performance is developed efficiently when the bent part of the piezoelectric fiber is small. Therefore, as a weave texture, twill weave is more preferred than plain weave, and satin weave is more preferred than twill weave. When satin weave has a step number of 3 to 7, the weave texture can be kept and a high level of piezoelectric performance can be obtained advantageously.

The weave texture is suitably selected according to a form change to be detected. For example, to detect bending, a plain weave texture and the parallel relationship between the piezoelectric fiber and the conductive fibers are preferred, and to detect twisting, a satin weave texture and the orthogonal relationship between the piezoelectric fiber and the conductive fibers are preferred.

Further, since the piezoelectric fiber tends to be electrified, an erroneous operation is apt to occur. In this case, the piezoelectric fiber which is to extract a signal may be earthed before use. As an earthing method, another conductive fiber is preferably arranged in addition to the conductive fibers for extracting a signal. In this case, the volume resistivity of this conductive fiber is preferably not more than 10⁻¹ Ω·cm, more preferably not more than 10⁻² Ω·cm, much more preferably not more than 10⁻³ Ω·cm.

### (a plurality of transducers)

A plurality of transducers may be arranged before use. They may be arranged in one level one-dimensionally or stacked two-dimensionally, woven or knitted into cloth, or braided. Thereby, a cloth-like or braid-like transducer can be obtained. To make a cloth-like or braid-like transducer, they may be combined with another fiber other than the transducer to be mixed, interwoven or interknitted, or incorporated into a resin before use as long as the object of the present invention is attained.

### (output of electric signal)

The transducer of the present invention can output surface contact, pressure or form change as an electric signal.

Examples of the form of the transducer of the present invention include clothing such as hats, gloves and socks, supporters and handkerchiefs. The transducer of the present invention may be used in touch panels, surface pressure-sensitive sensors for humans and animals, and sensors for detecting the bending, twisting and expansion/contraction of a j oint in these forms. For example, when it is used for humans, it detects contact and movement, thereby making it possible to use for medical applications such as the collection of information on the movement of a joint, for amusement applications and as an interface for moving a lost part or a robot. Further, it may be used as a surface pressure-sensitive sensor for stuffed toys and robots which imitate animals and humans, or a sensor for detecting the bending, twisting and expansion/contraction of a joint. Still further, it may be used as a surface pressure-sensitive sensor or form change sensor for bedclothing such as sheets and pillows, shoe soles, gloves, chairs, carpets, bags and flags.

Since the sensor of the present invention is in the form of cloth and therefore has stretchability and flexibility, it may be used as a surface pressure-sensitive sensor or form change sensor when it is attached to or covers all or part of the surface of any structure.

Since the transducer of the present invention can extract an electric signal as an output, it can be used as a power generation element as it uses this electric signal as a power source for moving another device or for power storage. Examples of the power generation include power generation by using the electric signal for the movable part of a human, animal, robot or machine which moves autonomously, power generation on the surface of a shoe sole, carpet or structure which receives pressure from outside, and power generation caused by a form change in a fluid. Since the transducer produces an electric signal by its form change in a fluid, it can suppress the adsorption or adhesion of a charged substance in a fluid.

### (input of electric signal)

The transducer of the present invention can indicate surface contact, pressure, form change or vibration by means of an electric signal.

Examples of the form of the transducer of the present invention include clothing such as hats, gloves and socks, supporters and handkerchiefs. The transducer of the present invention may be used as an actuator which applies pressure to the surface of a human or animal or as an actuator for supporting the bending, twisting or expansion/contraction of a joint in these forms. For instance, when it is used for humans, it may be used for amusement applications in which contact, movement or pressure is given and can move a lost part. Further, it may be used as an actuator for swelling or stretching the surface of a stuffed toy or robot which imitates an animal or human, or as an actuator for giving a movement such as bending, twisting or expansion/contraction to a joint. Further, it may be used as an actuator for moving the surfaces of bedclothing such as sheets and pillows, shoe soles, gloves, chairs, carpets, bags and flags, or as an actuator in any cloth-like form such as handkerchief, wrapping cloth or bag which change its form by an electric signal.

Further, since the actuator of the present invention is in the form of cloth and therefore has stretchability and flexibility, it may be used as an actuator which changes the form of a surface when it is attached to or covers all or part of the surface of any structure.

Since the transducer of the present invention can move with an electric signal as an input, it may be used as a speaker which generates sound by its vibration.

### (another embodiment 1 of piezoelectric element)

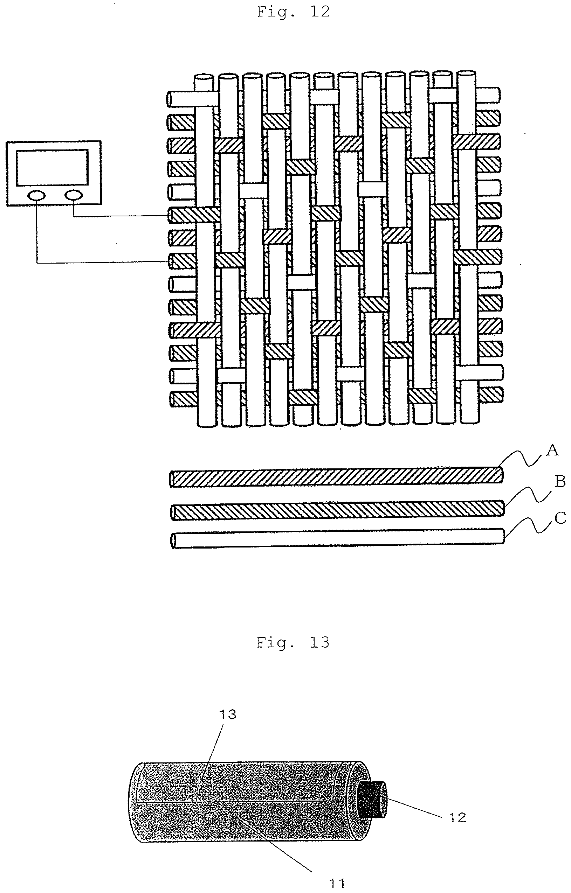

The present invention includes a transducer including the following piezoelectric element of another embodiment. (Fig. 13, Embodiment 8).
1. A piezoelectric element including a conductive fiber obtained by coating a fiber with an electric conductor, a piezoelectric polymer covering the surface of the conductive fiber and a surface conductive layer formed on the surface of the piezoelectric polymer.
2. The piezoelectric element in the above paragraph 1, wherein the piezoelectric polymer comprises polylactic acid as the main component.
3. The piezoelectric element in the above paragraph 1 or 2, wherein the piezoelectric polymer comprises poly-L-lactic acid or poly-D-lactic acid as the main component, and the optical purities of these are not less than 99 %.
4. The piezoelectric element in the above paragraph 2 or 3, wherein the piezoelectric polymer is uniaxially oriented and contains a crystal.
5. The piezoelectric element in any one of the above paragraphs 1 to 4, wherein the conductive fiber is a fiber obtained by coating a synthetic fiber with an electric conductor.
6. The piezoelectric element in any one of the above paragraphs 1 to 5 which is a sensor for detecting stress applied to the piezoelectric element and/or the application position of stress.
7. The piezoelectric element in the above paragraph 6, wherein stress applied to the piezoelectric element to be detected is rubbing force to the surface of the piezoelectric element.

### (conductive fiber)

The diameter of the conductive fiber is preferably 1 µm to 10 mm, more preferably 10 µm to 5 mm, much more preferably 0.1 to 2 mm. When the diameter is small, strength degrades and handling becomes difficult. When the diameter is large, flexibility is sacrificed. The cross-sectional shape of the conductive fiber is preferably circular or elliptic from the viewpoints of the design and production of the piezoelectric element but not limited to these. Although the piezoelectric polymer and the conductive fiber are preferably in as close contact as possible with each other, an anchor layer or an adhesive layer may be formed between the conductive fiber and the piezoelectric polymer to improve adhesion between them.

The base fiber (fiber to be coated with an electric conductor) of the conductive fiber is preferably a natural fiber, semi-natural fiber or synthetic fiber to improve durability.

Examples of the base fiber of the conductive fiber include natural fibers such as cotton, hemp and silk, semi-synthetic fibers such as rayon, cupra, triacetate and diacetate, polyester-based fibers and copolymer fibers thereof such as polyethylene terephthalate, polyethylene naphthalate, polylactic acid, polyglycolic acid and polybutylene succinate, polyamide-based fibers and copolymer fibers thereof such as nylon 6, nylon 66, nylon 46, nylon 410, nylon 610, nylon 10, nylon 11, nylon 12, nylon 6T, nylon 8T and nylon 10T, polyolefin-based fibers such as polyethylene and polypropylene, polyphenylene sulfide fibers, polycarbonate fibers, aramid fibers and other synthetic fibers. A composite fiber of two or more of these may also be used. A synthetic fiber is preferably used as the base fiber from the viewpoints of handling property and durability.

Any electric conductor to be coated on the surface of the base fiber may be used as long as it exhibits conductivity and the effect of the present invention is obtained.

For example, gold, silver, platinum, copper, nickel, tin, zinc, palladium, copper, indium tin oxide and mixtures and alloys thereof may be used. Any coating technique and means are acceptable. The present invention can be widely applied to fibers obtained by applying paste containing a metal and fibers coated with an electric conductor by electroplating, chemical plating or vacuum vapor deposition.

Conductive polymers such as polyaniline, polyacetylene, poly(p-phenylene vinylene), polypyrrole, polythiophene and poly(p-phenylene sulfide) may be used as the electric conductor. These electric conductors may be used in combination of two or more.

The conductive fiber is a multifilament which is a bundle of filaments. This multifilament may be used, or a monofilament may be used. Use of the multifilament is preferred from the viewpoint of the stability of electric properties in the longitudinal direction. The diameter of the monofilament is preferably 1 to 5, 000 µm, more preferably 2 to 100 µm, much more preferably 3 to 10 µm. The number of filaments is preferably 10 to 100,000, more preferably 100 to 50,000, much more preferably 500 to 30,000.

### (piezoelectric polymer)

The thickness of the piezoelectric polymer covering the conductive fiber is preferably 1 µm to 5 mm, more preferably 5 µm to 3 mm, much more preferably 10 µm to 1 mm, most preferably 20 µm to 0.5 mm. When the thickness is too small, a strength problem may occur, and when the thickness is too large, it may be difficult to extract an electric output.

As for the covered state of the conductive fiber with this piezoelectric polymer, the conductive fiber and a fiber composed of the piezoelectric polymer are preferably as concentric as possible to each other in order to keep a constant distance between the conductive fiber and the surface conductive layer. Although the method of forming a fiber including the conductive fiber and the fiber composed of the piezoelectric polymer is not particularly limited, there is one in which the conductive fiber on the inner side and the piezoelectric polymer on the outer side are co-extruded, melt spun and drawn. A method in which the outer surface of the conductive fiber is covered with the piezoelectric polymer which has been melt extruded and drawing stress is applied to draw and orient the piezoelectric polymer at the time of covering may be employed. Further, a method in which a hollow fiber composed of a drawn piezoelectric polymer is prepared and the conductive fiber is inserted into the fiber may also be used.

Moreover, a method in which the conductive fiber and a fiber composed of a drawn piezoelectric polymer are formed by separate steps and the fiber composed of a piezoelectric polymer is wound round the conductive fiber may be employed as well.

In this case, the conductive fiber is preferably covered with the above fiber to ensure that these fibers are as concentric as possible to each other. For example, a method in which the conductive fiber on the inner side, the piezoelectric polymer and the surface conductive layer are co-extruded, melt spun and drawn may be employed to form three layers at a time.

When the conductive fiber and the fiber composed of a drawn piezoelectric polymer are formed by separate steps and polylactic acid is used as the piezoelectric polymer, as preferred spinning and drawing conditions, the melt spinning temperature is preferably 150 to 250°C, the drawing temperature is preferably 40 to 150°C, the draw ratio is preferably 1.1 to 5.0 times, and the crystallization temperature is preferably 80 to 170°C.

Although any polymer which exhibits piezoelectricity, such as polyvinylidene fluoride or polylactic acid, may be used as the piezoelectric polymer, it preferably comprises polylactic acid as the main component. Polylactic acid is easily oriented by drawing after melt spinning to exhibit piezoelectricity and excellent in productivity as it does not require an electric field orientation treatment which is required for polyvinylidene fluoride. Further, since the piezoelectric fiber comprising polylactic acid has small polarization with tension or compression stress in the axis direction, it is difficult to make it function as a piezoelectric element. However, this is preferred for the piezoelectric element of the present invention having a constituent body which readily applies shearing stress to the piezoelectric polymer since it obtains a relatively large electric output with the shearing stress.

When the piezoelectric polymer fiber is wound round the conductive fiber to cover it, a multifilament which is a bundle of filaments or a monofilament may be used as the piezoelectric polymer fiber.

To wind the piezoelectric polymer fiber round the conductive fiber to cover it, for example, the piezoelectric polymer fiber is formed into a braided tube and the conductive fiber as a core is inserted into the tube to be covered. When the piezoelectric polymer fiber is to be braided to produce a braided cord, a braided cord which includes the conductive fiber as core yarn and the piezoelectric polymer fiber around the core yarn may be produced to cover the conductive fiber.

The single filament diameter is preferably 1 µm to 5 mm, more preferably 5 µm to 2 mm, much more preferably 10 µm to 1 mm. The number of filaments is preferably 1 to 100, 000, more preferably 50 to 50,000, much more preferably 100 to 20,000.

The piezoelectric polymer preferably comprises polylactic acid as the main component. The expression "as the main component" means that the content of polylactic acid is preferably not less than 90 mol%, more preferably not less than 95 mol%, much more preferably not less than 98 mol%.

When a multifilament is used as the conductive fiber, the piezoelectric polymer may cover the multifilament in such a manner that it is in contact with at least part of the surface (fiber outer surface) of the multifilament, and may or may not cover the surfaces (fiber outer surfaces) of all the filaments constituting the multifilament. The covered state.of each of the inside filaments constituting the multifilament should be suitably set in consideration of the performance and handling property of the piezoelectric element.

An example of the polylactic acid is poly-L-lactic acid obtained by polymerizing L-lactic acid or L-lactide according to the crystal structure. Another example of the polylactic acid is poly-D-lactic acid obtained by polymerizing D-lactic acid or D-lactide. Still another example is stereocomplex polylactic acid having the hybrid structure of poly-L-lactic acid and poly-D-lactic acid. Any polylactic acid is acceptable if it exhibits piezoelectricity. Poly-L-lactic acid and poly-D-lactic acid are preferred as they have a high piezoelectric modulus. Since the polarizations of poly-L-lactic acid and poly-D-lactic acid are opposite to each other with the same stress, it is possible to use a combination of these according to purpose.

The optical purity of the polylactic acid is preferably not less than 99 %, more preferably not less than 99.3 %, much more preferably not less than 99.5 %. When the optical purity is lower than 99 %, the piezoelectric modulus may significantly drop, thereby making it difficult to obtain a sufficiently high electric output with rubbing force to the surface of the piezoelectric element.

Preferably, the piezoelectric polymer comprises poly-L-lactic acid or poly-D-lactic acid as the main component, and the optical purities of these components are not less than 99 %.

Preferably, the piezoelectric polymer is uniaxially oriented and contains a crystal. More preferably, it is uniaxially oriented polylactic acid having a crystal. This is because polylactic acid exhibits great piezoelectricity when it is crystalline and uniaxially oriented.

Since polylactic acid is a polyester which is hydrolyzed relatively quickly, when it has a problem with moist heat resistance, a known hydrolysis inhibitor such as an isocyanate, epoxy or carbodiimide compound may be added. An antioxidant such as a phosphoric acid-based compound, plasticizer and optical deterioration inhibitor may be added as required to improve physical properties. Further, the polylactic acid may be used in combination with another polymer as an alloy. When the polylactic acid is used as the main piezoelectric polymer, it is contained in an amount of preferably at least 50 wt%, more preferably at least 70 wt%, most preferably at least 90 wt%.

In the case of a polylactic acid alloy, preferred examples of a polymer other than polylactic acid include polybutylene terephthalate, polyethylene terephthalate, polyethylene naphthalate copolymers and polymethacrylate. However, the polymer is not limited to these and any polymer may be used as long as the effect of the present invention is obtained.

### (surface conductive layer)

Any material may be used as the material of the surface conductive layer if it exhibits conductivity. Examples of the material include coats of paste containing a metal such as gold, silver or copper, vapor-deposited films of gold, silver, copper and indium tin oxide, and conductive polymers such as polyaniline, polyacetylene, poly(p-phenylene vinylene), polypyrrole, polythiophene, poly(p-phenylene sulfide) and carbon fiber. To keep high conductivity, the volume resistivity is preferably not more than 10⁻¹ Ω·cm, more preferably not more than 10⁻² Ω·cm, much more preferably not more than 10⁻³ Ω·cm.

The thickness of this surface conductive layer is preferably 10 nm to 100 µm, more preferably 20 nm to 10 µm, much more preferably 30 nm to 3 µm. When the thickness is too small, conductivity degrades and an electric output may be hardly obtained and when the thickness is too large, flexibility may be lost.

The surface conductive layer may be formed on the surface of the piezoelectric polymer entirely or discretely. Since this arrangement method may be designed according to purpose, this arrangement is not particularly limited. By arranging this surface conductive layer discretely and extracting an electric output from the discrete surface conductive layers, the intensity and position of stress applied to the piezoelectric element can be detected.

In order to protect the surface conductive layer, that is, prevent the surface conductive layer which is the outermost layer from contact by a human hand, some kind of protective layer may be formed. This protective layer is preferably insulating, more preferably made of a polymer from the viewpoint of flexibility. As a matter of course, the protective layer is rubbed in this case and not particularly limited if shearing stress produced by this rubbing can reach the piezoelectric polymer and induce its polarization. The protective layer is not limited to a protective layer which is formed by coating a polymer but may be a film or a combination of a protective layer and a film. An epoxy resin and an acrylic resin are preferably used for the protective layer.

The thickness of the protective layer is preferably as small as possible since shearing force can be easily transmitted to the piezoelectric polymer. However, when the thickness is too small, a problem such as destruction tends to occur. Therefore, it is preferably 10 nm to 200 µm, more preferably 50 nm to 50 µm, much more preferably 70 nm to 30 µm, most preferably 100 nm to 10 µm.

Although there is a case where only one piezoelectric element is used, a plurality of piezoelectric elements may be used in combination, woven or knitted into cloth, or braided. Thereby, a cloth or braided piezoelectric element can be obtained. To produce a cloth or braided piezoelectric element, as long as the object of the present invention is attained, a fiber other than the piezoelectric element may be used in combination to carry out mixing, interweaving or interknitting. Further, the piezoelectric element may be incorporated into the resin of the housing of a smart phone.

### (still another embodiment 2 of piezoelectric element)

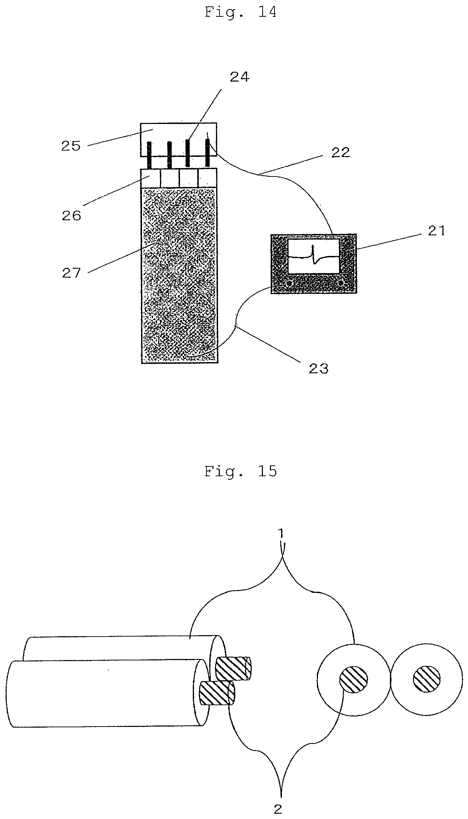

The present invention includes a transducer including the following piezoelectric element of still another embodiment(Fig. 15, Example 9).
1. A piezoelectric element including at least two covered fibers which are prepared by covering with a piezoelectric, polymer the surfaces of conductive fibers obtained by coating fibers with an electric conductor, wherein the covered fibers are arranged substantially parallel to each other and the piezoelectric polymers on the surfaces are in contact with each other.
2. The piezoelectric element in the above paragraph 1, wherein the piezoelectric polymer comprises polylactic acid as the main component.
3. The piezoelectric element in the above paragraph 1 or 2, wherein the piezoelectric polymer comprises poly-L-lactic acid or poly-D-lactic acid as the main component, and the optical purities of these components are not less than 99 %.
4. The piezoelectric element in any one of the above paragraphs 1 to 3, wherein the piezoelectric polymer is uniaxially oriented and contains a crystal.
5. The piezoelectric element in any one of the above paragraphs 1 to 4, wherein the conductive fibers are fibers obtained by coating synthetic fibers with an electric conductor.
6. The piezoelectric element in any one of the above paragraphs 1 to 5 which is a sensor for detecting the size and/or application position of stress applied to the piezoelectric element.
7. The piezoelectric element in the above paragraph 6, wherein stress applied to the piezoelectric element to be detected is rubbing force to the surface of the piezoelectric element.

### (covered fiber)

The piezoelectric element of the present invention includes at least two covered fibers prepared by covering the surfaces of conductive fibers with a piezoelectric polymer.

Fig. 15 is a schematic view of one embodiment of the piezoelectric element. In Fig. 15, reference numeral 1 denotes the piezoelectric polymer, and 2 the conductive fiber.

Although the length of the piezoelectric element is not particularly limited, the piezoelectric element is produced continuously and then may be cut to a desired length before use. For the actual use of the piezoelectric element, the length is 1 mm to 10 m, preferably 5 mm to 2 m, more preferably 1 cm to 1 m. When the length is small, convenience that the piezoelectric element has a fibrous form is lost and when the length is large, there occurs a problem such as a drop in electric output due to a problem with the resistance value of the conductive fiber.

### (conductive fiber)

As the material of the conductive fiber, a fiber obtained by coating the surface of a natural fiber, semi-natural fiber or synthetic fiber with an electric conductor is preferred to provide durability. To extract an electric output from the piezoelectric polymer efficiently, the electric resistance is preferably low. The volume resistivity is preferably not more than 10⁻¹ Ω·cm, more preferably not more than 10⁻² Ω·cm, much more preferably not more than 10⁻³ Ω·cm.

The base fiber (fiber to be coated with an electric conductor) of the conductive fiber is preferably a natural fiber, semi-natural fiber or synthetic fiber to improve durability.

Examples of the base fiber of the conductive fiber include natural fibers such as cotton, hemp and silk, semi-synthetic fibers such as rayon, cupra, triacetate and diacetate, polyester-based fibers and copolymer fibers thereof such as polyethylene terephthalate, polyethylene naphthalate, polylactic acid, polyglycolic acid and polybutylene succinate, polyamide-based fibers and copolymer fibers thereof such as nylon 6, nylon 66, nylon 46, nylon 410, nylon 610, nylon 10, nylon 11, nylon 12, nylon 6T, nylon 8T and nylon 10T, polyolefin-based fibers such as polyethylene and polypropylene, polyphenylene sulfide fibers, polycarbonate fibers, aramid fibers and other synthetic fibers. A composite fiber of two or more of these may also be used. A synthetic fiber is preferably used as the base fiber from the viewpoints of handling property and durability.

Any electric conductor may be used as the electric conductor to be coated on the surface of the base fiber as long as the effect of the present invention is obtained.

For example, gold, silver, platinum, copper, nickel, tin, zinc, palladium, copper, indium tin oxide and mixtures and alloys thereof may be used. Any coating technique and means are acceptable. The present invention can be widely applied to fibers obtained by applying paste containing a metal and fibers coated with an electric conductor by electroplating, chemical plating or vacuum vapor deposition.

Conductive polymers such as polyaniline, polyacetylene, poly(p-phenylene vinylene), polypyrrole, polythiophene and poly(p-phenylene sulfide) may be used as the electric conductor. These electric conductors may be used in combination of two or more.

The diameter of the conductive fiber is preferably 1 µm to 10 mm, more preferably 10 µm to 5 mm, much more preferably 0.1 to 2 mm. When the diameter is small, strength degrades and handling becomes difficult. When the diameter is large, flexibility is sacrificed.

The cross-sectional shape of the conductive fiber is preferably circular or elliptic from the viewpoints of the design and production of the piezoelectric element but not limited to these. As a matter of course, only one conductive fiber may be used, or a bundle of conductive fibers may be used.

The conductive fiber is generally a multifilament which is a bundle of filaments. This multifilament may be used, or a monofilament may be used. Use of the multifilament is preferred from the viewpoint of the stability of electric properties in the longitudinal direction.

The diameter of the monofilament is preferably 1 to 5,000 µm, more preferably 2 to 100 µm, much more preferably 3 to 10 µm. The number of filaments is preferably 10 to 100,000, more preferably 100 to 50, 000, much more preferably 500 to 30,000.

### (piezoelectric polymer)

Although any polymer which exhibits piezoelectricity, such as polyvinylidene fluoride or polylactic acid, may be used as the piezoelectric polymer, it preferably comprises polylactic acid as the main component. Polylactic acid is easily oriented by drawing after melt spinning to exhibit piezoelectricity and excellent in productivity as it does not require an electric field orientation treatment which is required for polyvinylidene fluoride. Further, since the piezoelectric fiber comprising polylactic acid has small polarization with tension or compression stress in the axis direction, it is difficult to make it function as a piezoelectric element. However, this is preferred for the piezoelectric element of the present invention having a constituent body which readily applies shearing stress to the piezoelectric polymer since it obtains a relatively large electric output with the shearing stress.

The piezoelectric polymer preferably comprises polylactic acid as the main component. The expression "as the main component" means that the content of polylactic acid is preferably not less than 90 mol%, more preferably not less than 95 mol%, much more preferably not less than 98 mol%.

An example of the polylactic acid is poly-L-lactic acid obtained by polymerizing L-lactic acid or L-lactide according to the crystal structure. Another example of the polylactic acid is poly-D-lactic acid obtained by polymerizing D-lactic acid or D-lactide. Still another example is stereocomplex polylactic acid having the hybrid structure of poly-L-lactic acid and poly-D-lactic acid. Any polylactic acid is acceptable if it exhibits piezoelectricity. Poly-L-lactic acid and poly-D-lactic acid are preferred as they have a high piezoelectric modulus. Since the polarizations of poly-L-lactic acid and poly-D-lactic acid are opposite to each other with the same stress, it is possible to use a combination of these according to purpose.

The optical purity of the polylactic acid is preferably not less than 99 %, more preferably not less than 99.3 %, much more preferably not less than 99.5 %. When the optical purity is lower than 99 %, the piezoelectric modulus may significantly drop, thereby making it difficult to obtain a sufficiently high electric output with rubbing force to the surface of the piezoelectric element. Preferably, the piezoelectric polymer comprises poly-L-lactic acid or poly-D-lactic acid as the main component, and the optical purities of these components are not less than 99 %.

Preferably, the piezoelectric polymer is uniaxially oriented in the fiber axis direction of the covered fiber and contains a crystal. More preferably, it is uniaxially oriented polylactic acid having a crystal. This is because polylactic acid exhibits great piezoelectricity when it is crystalline and uniaxially oriented.

Since polylactic acid is a polyester which is hydrolyzed relatively quickly, when it has a problem with moist heat resistance, a hydrolysis inhibitor such as isocyanate compound, oxazoline compound, epoxy compound or carbodiimide compound may be added. An antioxidant such as a phosphoric acid-based compound, plasticizer and optical degradation inhibitor may be added as required to improve physical properties.

Further, polylactic acid may be used in combination with another polymer as an alloy. When polylactic acid is used as the main piezoelectric polymer, it is contained in an amount of preferably at least 50 wt%, more preferably at least 70 wt%, most preferably at least 90 wt%.

In the case of a polylactic acid alloy, preferred examples of a polymer other than polylactic acid include polybutylene terephthalate, polyethylene terephthalate, polyethylene naphthalate copolymer and polymethacrylate. However, the polymer is not limited to these and any polymer may be used as long as the effect of the present invention is obtained.

### (covering)

The surface of each conductive fiber is covered with the piezoelectric polymer. The thickness of the piezoelectric polymer covering the conductive fiber is preferably 1 µm to 10 mm, more preferably 5 µm to 5 mm, much more preferably 10 µm to 3 mm, most preferably 20 µm to 1 mm. When the thickness is too small, a strength problem may occur, and when the thickness is too large, it may be difficult to extract an electric output.

Preferably, the piezoelectric polymer and the conductive fiber are in as close contact as possible with each other. To improve adhesion, an anchor layer or an adhesive layer may be formed between the conductive fiber and the piezoelectric polymer.

The covering method and form are not particularly limited as long as an electric output can be obtained by applied stress. For example, like the manufacture of an electric wire, the conductive fiber is covered with the molten piezoelectric polymer, piezoelectric polymer yarn is wound round the conductive fiber, or the conductive fiber is sandwiched between piezoelectric polymer films to be bonded. Three or more conductive fibers may be prepared when the conductive fibers are to be covered with the piezoelectric polymer. Further, after only one conductive fiber is covered with the piezoelectric polymer, the surface of the piezoelectric polymer is bonded, thereby making it possible to obtain the piezoelectric element of the present invention. The bonding method is not particularly limited but use of an adhesive or welding may be employed. The conductive fiber and the piezoelectric polymer may be merely in close contact with each other.

As for the covered state of the conductive fiber with the piezoelectric polymer, although the forms of the conductive fiber and the piezoelectric polymer are not particularly limited, for example, to obtain the piezoelectric element of the present invention by bonding a fiber prepared by covering one conductive fiber with the piezoelectric polymer afterward, it is preferred that they should be as concentric as possible to each other in order to keep a constant distance between the conductive fibers.

When a multifilament is used as the conductive fiber, the piezoelectric polymer should cover the multifilament in such a manner that it is in contact with at least part of the surface (fiber outer surface) of the multifilament.

The piezoelectric polymer may cover the surfaces (fiber outer surfaces) of all the filaments constituting the multifilament. The covered state of each of the inside filaments constituting the multifilament should be suitably set in consideration of the performance and handling property of the piezoelectric element. The piezoelectric element of the present invention includes at least two conductive fibers, and the number of conductive fibers is not limited to two and may be more.

### (parallelism)

The conductive fibers are arranged substantially parallel to each other. The distance between the conductive fibers is preferably 1 µm to 10 mm, more preferably 5 µm to 5 mm, much more preferably 10 µm to 3 mm, most preferably 20 µm to 1 mm. When the distance is too small, a strength problem may occur and when the distance is too large, it may be difficult to extract an electric output. The expression "substantially parallel to each other" means that a plurality of conductive fibers are arranged not in contact with each other, and the permissible deviation angle differs according to the fiber length of the conductive fiber.

### (contact)

The piezoelectric polymers on the surfaces of the covered fibers are in contact with each other. There is an embodiment in which the surface cover layers of covered fibers, each including the conductive fiber as a core and the piezoelectric polymer as a cover layer, are in contact with each other. There is another embodiment in which a plurality of conductive fibers arranged parallel to each other are sandwiched between two piezoelectric polymer films to be covered.

### (production method (i))

The piezoelectric element can be manufactured by bonding together at least two covered fibers, each prepared by covering the surface of one conductive fiber with the piezoelectric polymer. Examples of this method are given below.
(i-1) A method comprising the steps of: coextruding a conductive fiber on the inner side and a piezoelectric polymer on the outer side, and melt spinning and drawing the co-extruded product.
(ii-2) A method comprising the steps of: covering a conductive fiber with a melt extruded piezoelectric polymer and applying drawing stress at the time of covering to draw and orient the piezoelectric polymer.
(iii-3) A method comprising the steps of: preparing a hollow fiber composed of a drawn piezoelectric polymer and inserting a conductive fiber into the fiber.
(iv-4) A method comprising the steps of: preparing a conductive fiber and a fiber composed of a drawn piezoelectric polymer by separate steps and winding the fiber composed of a piezoelectric polymer round the conductive fiber to cover the conductive fiber. In this case, the conductive fiber is preferably covered to ensure that both fibers are as concentric as possible to each other.

In this case, as preferred spinning and drawing conditions when polylactic acid is used as the piezoelectric polymer, the melt spinning temperature is preferably 150 to 250°C, the drawing temperature is preferably 40 to 150°C, the draw ratio is preferably 1.1 to 5.0 times, and the crystallization temperature is preferably 80 to 170°C.

A multifilament which is a bundle of filaments or a monofilament may be used as the piezoelectric polymer fiber to be wound.

To wind the piezoelectric polymer fiber round the conductive fiber, for example, the fiber composed of a piezoelectric polymer is formed into a braided tube, and the conductive fiber as a core is inserted into the tube to be covered. Further, when the fiber composed of a piezoelectric polymer is braided to produce a braided cord, a braided cord which includes the conductive fiber as core yarn and the piezoelectric polymer fiber around the core yarn is produced to cover the conductive fiber. The single filament diameter of the fiber composed of a piezoelectric polymer is preferably 1 µm to 5 mm, more preferably 5 µm to 2 mm, much more preferably 10 µm to 1 mm. The number of filaments is preferably 1 to 100,000, more preferably 50 to 50,000, much more preferably 100 to 20,000.

The piezoelectric element of the present invention can be obtained by bonding together a plurality of covered fibers produced by covering the surfaces of the conductive fibers with the piezoelectric polymer according to the above method.

### (production method (ii))

The piezoelectric element can also be obtained by covering a plurality of conductive fibers arranged parallel to each other with a piezoelectric polymer. For example, the piezoelectric element can be obtained by sandwiching a plurality of conductive fibers arranged parallel to each other between two piezoelectric polymer films. Also, a piezoelectric element having excellent flexibility can be obtained by cutting this piezoelectric element into a strip.

### (protective layer)

A protective layer may be formed on the outermost surface of the piezoelectric element. This protective layer is preferably insulating, more preferably made of a polymer from the viewpoint of flexibility. As a matter of course, the protective layer is rubbed in this case and not particularly limited if shearing stress produced by this rubbing can reach the piezoelectric polymer and induce its polarization. The protective layer is not limited to one which is formed by coating a polymer but may be a film or a combination of a protective layer and a film. An epoxy resin and an acrylic resin are preferably used for the protective layer.

The thickness of the protective layer is preferably as small as possible since shearing force can be easily transmitted to the piezoelectric polymer. When the thickness is too small, a problem such as the destruction of the protective layer tends to occur. Therefore, the thickness of the protective layer is preferably 10 nm to 200 µm, more preferably 50 nm to 50 µm, much more preferably 70 nm to 30 µm, most preferably 100 nm to 10 µm. The shape of the piezoelectric element can be formed by this protective layer.

### (a plurality of piezoelectric elements)

A plurality of piezoelectric elements may be used in combination. They may be arranged in one level one-directionally, stacked two-dimensionally, woven or knitted into cloth, or braided. Thereby, a cloth or braided piezoelectric element can be obtained. To produce a cloth or braided piezoelectric element, as long as the object of the present invention is attained, a fiber other than the piezoelectric element may be used in combination to carry out mixing, interweaving or interknitting, or incorporated into the resin of the housing of a smart phone. When a plurality of the piezoelectric elements are used in combination, as the piezoelectric elements do not have an electrode on the surface, the arrangement and braiding of these can be selected from wide ranges.

### (application technology of piezoelectric element)

The piezoelectric element according to any one of the above embodiments may be used as a sensor for detecting the size and/or application position of stress applied by rubbing the surface of the piezoelectric element. The piezoelectric element can extract an electric output when shearing stress is applied to the piezoelectric polymer by pressing force other than rubbing as a matter of course.

The expression "applied stress" means stress produced by rubbing with the surface of a finger as described in the object of the invention. The level of stress produced by rubbing with the surface of a finger is approximately 1 to 100 Pa. As a matter of course, it is needless to say that if the stress is larger than this range, it is possible to detect applied stress and the application position thereof.

In the case of input with a finger, the piezoelectric element operates under a load of preferably 1 to 50 gf (10 to 500 mmN), more preferably 1 to 10 gf (10 to 100 mmN). As a matter of course, the piezoelectric element operates under a load of more than 50 gf (500 mmN) as described above.

The piezoelectric element according to any one of the above embodiments may be used as an actuator by applying an electric signal thereto. Therefore, the piezoelectric element may be used as a cloth actuator. By controlling an electric signal to be applied, a concave or convex part can be formed in part of the surface of the cloth of the actuator, or the whole cloth can be rolled. The actuator of the present invention can hold goods. When it is formed to be wound round a human body (arm, leg, hip, etc.), it can function as a supporter.

### EXAMPLES

The following examples are provided for the purpose of further illustrating the present invention but are in no way to be taken as limiting.

### Example 1

### (production of polylactic acid)

The polylactic acid used in Example 1 was manufactured by the following method.

0.005 part by weight of tin octylate was added to 100 parts by weight of L-lactide (manufactured by Musashino Chemical Laboratory, Ltd., optical purity of 100 %) to carry out a reaction in a nitrogen atmosphere at 180°C for 2 hours in a reactor equipped with a stirring blade, phosphoric acid was added in an amount which was 1.2 times the equivalent of tin octylate, the residual lactide was removed under a reduced pressure of 13.3 Pa, and the resulting product was formed into a chip to obtain poly-L-lactic acid (PLLA1). The obtained PLLA1 had a weight average molecular weight of 152, 000, a glass transition point (Tg) of 55°C and a melting point of 175°C.

### (piezoelectric fiber)

PLLA1 molten at 240°C was discharged from a cap having 24 holes at a rate of 20 g/min and taken up at a rate of 887 m/min. This undrawn multifilament yarn was drawn to 2.3 times at 80°C and heat set at 100°C to obtain multifilament uniaxially drawn yarn 1 having a fineness of 84 dTex/24 filaments. 8 of the multifilament uniaxially drawn yarns were bundled to obtain a piezoelectric fiber 1.

### (conductive fiber)

A carbon fiber multifilament manufactured by Toho Tenax Co., Ltd. (trade name of HTS40 3K) was used as a conductive fiber 1. This conductive fiber 1 was a multifilament which was a bundle of 3,000 filaments having a diameter of 7.0 µm and had a volume resistivity of 1.6 x 10⁻³ Ω·cm.

### (insulating fiber)

Polyethylene terephthalate molten at 280°C was discharged from a cap having 48 holes at a rate of 45 g/min and taken up at a rate of 800 m/min. This undrawn yarn was drawn to 2.5 times at 80°C and heat set at 180°C to obtain multifilament drawn yarn having a fineness of 167 dTex/48 filaments. 4 of the multifilament drawn yarns were bundled to obtain an insulating fiber 1.

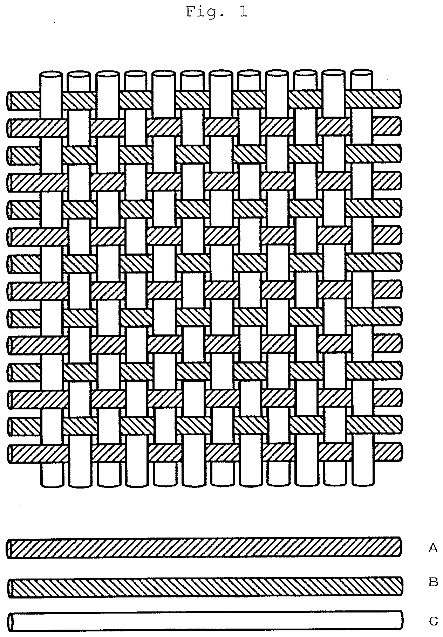

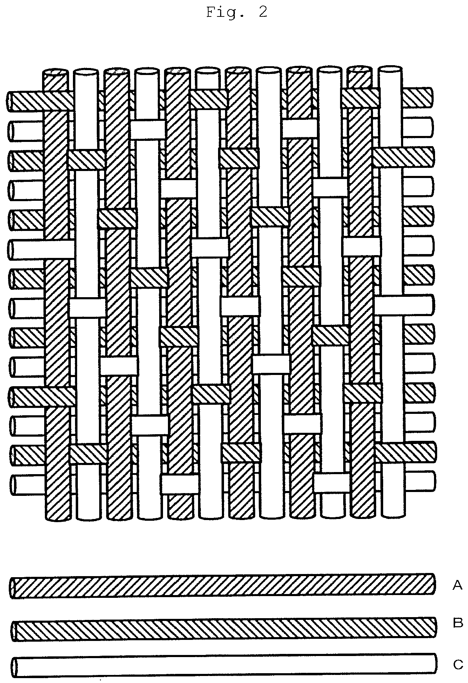

As shown in Fig. 1, a plain woven fabric 1 was manufactured by arranging the insulating fibers 1 as a warp and the piezoelectric fibers 1 and the conductive fibers 1 alternately as wefts. As shown in Fig. 2, a satin woven fabric 1 was manufactured by arranging the piezoelectric fibers 1 and the insulating fibers 1 alternately as warps and the conductive fibers 1 and the insulating fibers 1 alternately as wefts.

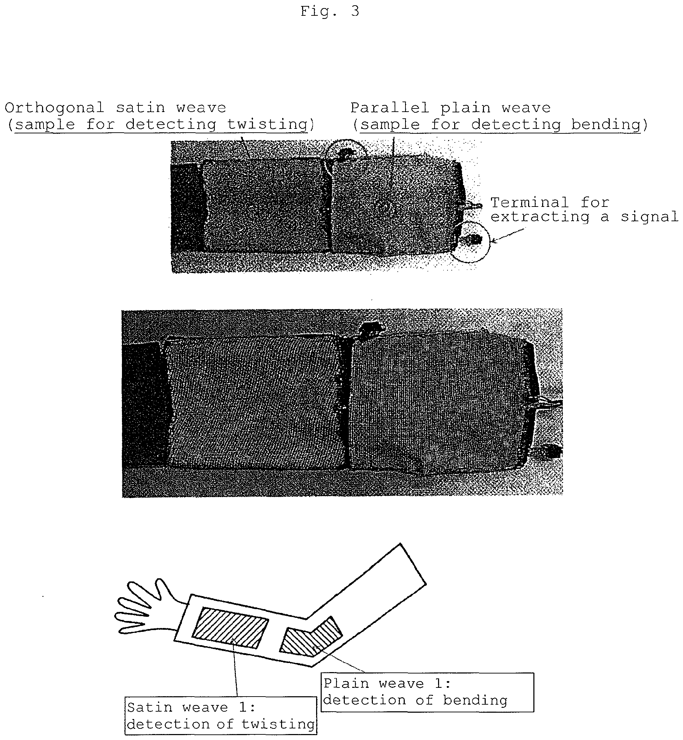

The above plain woven fabric 1 and the satin woven fabric 1 were sewed to a sleeve as shown in Fig. 3.

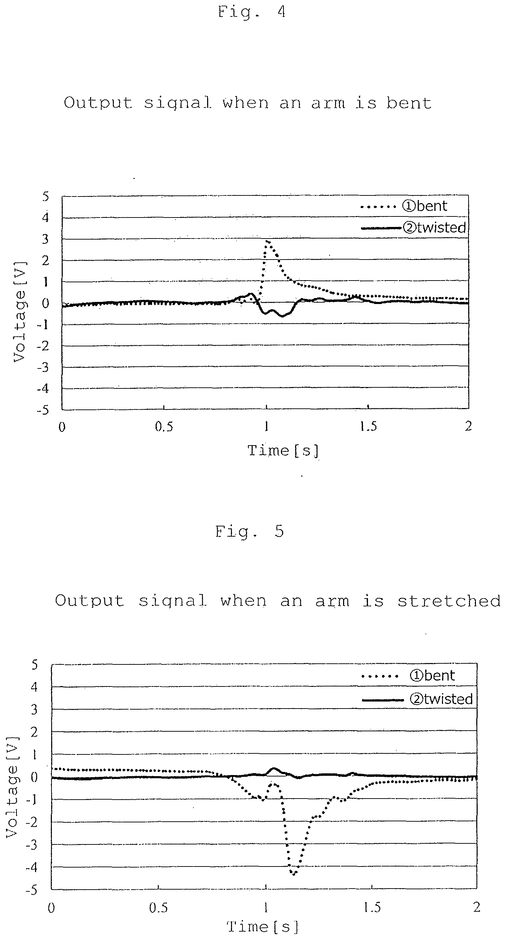

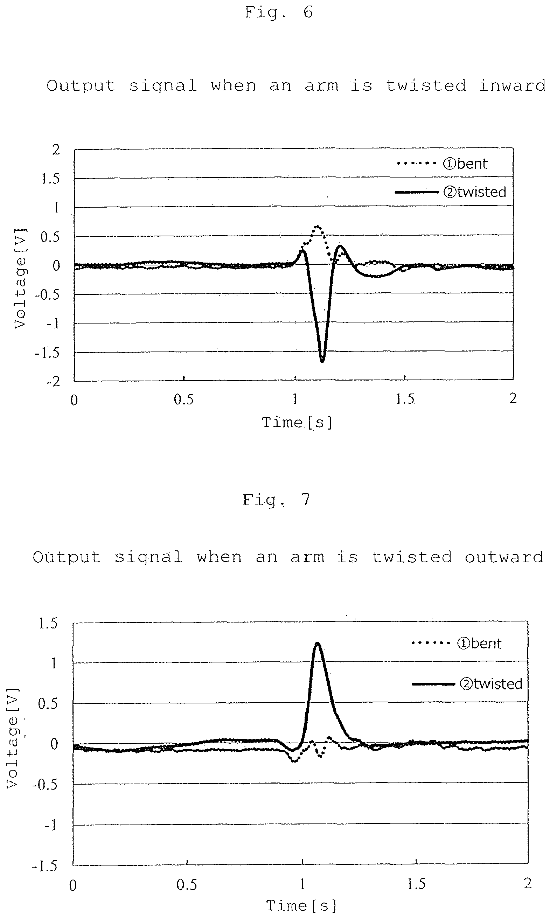

A pair of the conductive fibers sandwiching the piezoelectric fiber of each of these woven fabrics were connected as signal lines to an oscilloscope (the DL6000 series digital oscilloscope (trade name of DL6000) of Yokokawa Electric Corporation). When an arm was bent or twisted while the signal lines were connected, voltage signals shown in Figs. 4 to 7 were obtained, opposite signals could be obtained independently according to the bending and twisting directions, and a cloth joint sensor having high flexibility could be obtained.

### Example 2

### (production of polylactic acid)

The polylactic acid used in Example 2 was manufactured by the following method.

0.005 part by weight of tin octylate was added to 100 parts by weight of L-lactide (manufactured by Musashino Chemical Laboratory, Ltd., optical purity of 100 %) to carry out a reaction in a nitrogen atmosphere at 180°C for 2 hours in a reactor equipped with a stirring blade, phosphoric acid was added in an amount which was 1.2 times the equivalent of tin octylate, the residual lactide was removed under a reduced pressure of 13.3 Pa, and the resulting product was formed into a chip to obtain poly-L-lactic acid (PLLA1). The obtained PLLA1 had a weight average molecular weight of 152, 000, a glass transition point (Tg) of 55°C and a melting point of 175°C.

### (piezoelectric fiber)

PLLA1 molten at 240°C was discharged from a cap having 24 holes at a rate of 20 g/min and taken up at a rate of 887 m/min. This undrawn multifilament yarn was drawn to 2.3 times at 80°C and heat set at 100°C to obtain multifilament uniaxially drawn yarn 1 having a fineness of 84 dTex/24 filaments. 8 of the multifilament uniaxially drawn yarns were bundled to obtain a piezoelectric fiber 1.

### (conductive fiber)

A carbon fiber multifilament manufactured by Toho Tenax Co., Ltd. (trade name of HTS40 3K) was used as a conductive fiber 1. This conductive fiber 1 was a multifilament which was a bundle of 3,000 filaments having a diameter of 7.0 µm and had a volume resistivity of 1.6 x 10⁻³ Ω·cm.

### (insulating fiber)

Polyethylene terephthalate molten at 280°C was discharged from a cap having 48 holes at a rate of 45 g/min and taken up at a rate of 800 m/min. This undrawn yarn was drawn to 2.5 times at 80°C and heat set at 180°C to obtain multifilament drawn yarn having a fineness of 167 dTex/48 filaments. 4 of the multifilament drawn yarns were bundled to obtain an insulating fiber 1.

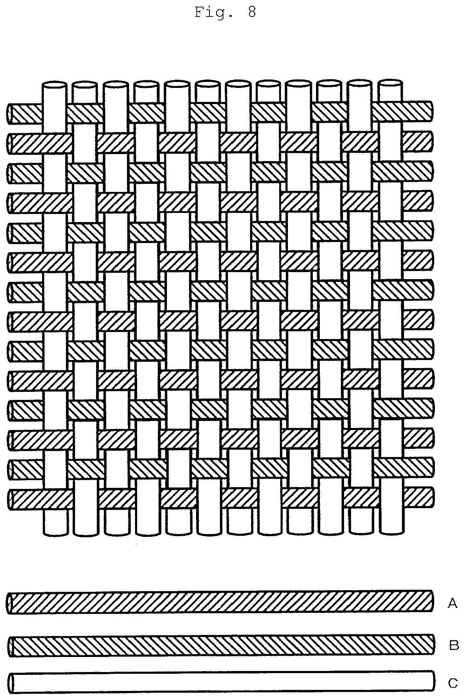

As shown in Fig. 8, a plain woven fabric 1 was manufactured by arranging the insulating fibers 1 as a warp and the piezoelectric fibers 1 and the conductive fibers 1 alternately as wefts. When this plain woven fabric was cut to 10 mm in the warp direction and to 100 mm in the weft direction and a voltage of 5 kV at 5.8 Hz was applied to a pair of the conductive fibers sandwiching the piezoelectric fiber, the plain woven fabric 1 was bent 500 µm, and it was thus confirmed that it functioned as an actuator.

### Examples 3 to 6

### (production of polylactic acid)

The polylactic acid used in Examples 3 to 6 was manufactured by the following method.

0.005 part by weight of tin octylate was added to 100 parts by weight of L-lactide (manufactured by Musashino Chemical Laboratory, Ltd., optical purity of 100 %) to carry out a reaction in a nitrogen atmosphere at 180°C for 2 hours in a reactor equipped with a stirring blade, phosphoric acid was added in an amount which was 1.2 times the equivalent of tin octylate, the residual lactide was removed under a reduced pressure of 13.3 Pa, and the resulting product was formed into a chip to obtain poly-L-lactic acid (PLLA1). The obtained PLLA1 had a weight average molecular weight of 150,000, a glass transition point (Tg) of 55°C and a melting point of 175°C.

### (evaluation of piezoelectric element)

The piezoelectric element was evaluated as follows in Examples 3 to 6.

Piezoelectric characteristics were evaluated by deforming the piezoelectric element. The evaluation system is shown in Fig. 2. For voltage evaluation, the DL6000 series digital oscilloscope (trade name of DL6000) of Yokokawa Electric Corporation was used.

The piezoelectric fiber, the conductive fiber and the insulating fiber used in Examples 3 to 6 were manufactured by the following methods.

### (piezoelectric fiber)

PLLA1 molten at 240°C was discharged from a cap having 24 holes at a rate of 20 g/min and taken up at a rate of 887 m/min. This undrawn multifilament yarn was drawn to 2.3 times at 80°C and heat set at 100°C to obtain multifilament uniaxially drawn yarn 1 having a fineness of 84 dTex/24 filaments. 8 of the multifilament uniaxially drawn yarns were bundled to obtain a piezoelectric fiber 1.

### (conductive fiber)

A copper deposited aramid fiber manufactured by Teijin Limited was used as a conductive fiber, covered concentrically with PLLA1 molten at a resin temperature of 200°C and cooled in air immediately to obtain a covered fiber 1 having a length of 10 m.

The copper deposited aramid fiber in the covered fiber 1 is the conductive fiber in the present invention and had a volume resistivity of 1. 0 x 10⁻² Ω·cm. The diameter of this conductive fiber was 0. 6 mm, and the thickness of the covered PLLA1 layer was 0.3 mm (diameter of the covered fiber 1 was 1.2 mm).

### (insulating fiber)

PET1 molten at 280 °C was discharged from a cap having 48 holes at a rate of 45 g/min and taken up at a rate of 800 m/min. This undrawn yarn was drawn to 2.5 times at 80°C and heat set at 180°C to obtain multifilament drawn yarn having a fineness of 167 dTex/48 filaments. 4 of the multifilament drawn yarns were bundled to obtain an insulating fiber 1.

### Example 3

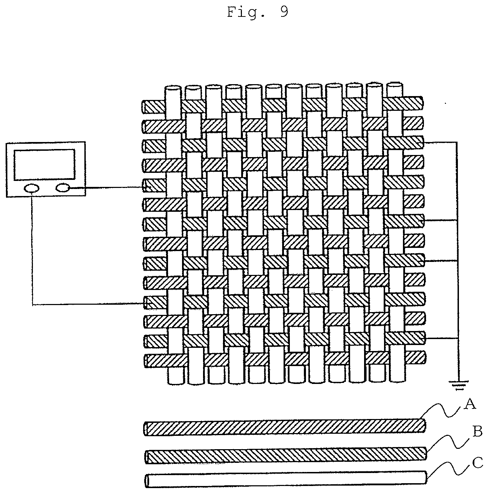

As shown in Fig. 9, a plain woven fabric was manufactured by arranging the insulating fibers 1 as a warp and the piezoelectric fibers 1 and the conductive fibers 1 alternately as wefts. A pair of the conductive fibers sandwiching the piezoelectric fibers of this woven fabric were connected as signal lines to an oscilloscope and other conductive fibers were connected to an earth. When the piezoelectric fibers sandwiched between the conductive fibers connected to the signal lines were rubbed with a finger or bent, about 0.02 to 0.03 V voltage signal was obtained. It was confirmed that this plain woven fabric functioned as a piezoelectric element (sensor). As a result of durability evaluation, even after 2, 000 folding tests, piezoelectricity was kept at not less than 90 %.

### Example 4

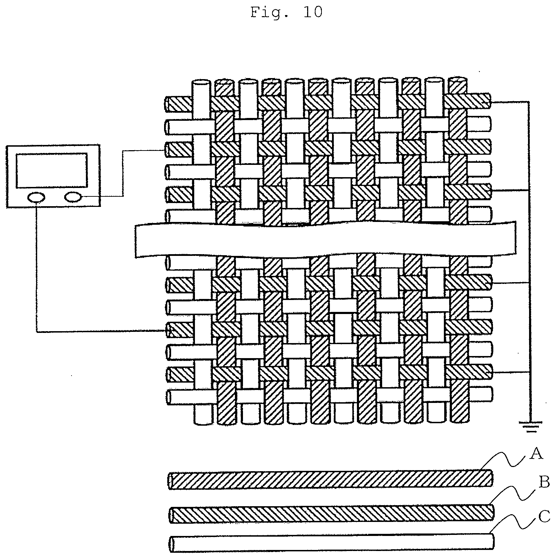

As shown in Fig. 10, a plain woven fabric was manufactured by arranging the piezoelectric fibers 1 and the insulating fibers 1 alternately as warps and the conductive fibers 1 and the insulating fibers 1 alternately as wefts. A pair of the conductive fibers 20 mm apart from each other of this woven fabric were connected as signal lines to an oscilloscope and other conductive fibers were connected to an earth. When the piezoelectric fibers sandwiched between the conductive fibers connected to the signal lines were rubbed with a finger, about 0.01 V voltage signal was obtained. It was confirmed that this plain woven fabric functioned as a piezoelectric element (sensor). As a result of durability evaluation, even after 2,000 folding tests, piezoelectricity was kept at not less than 90 %.

### Example 5

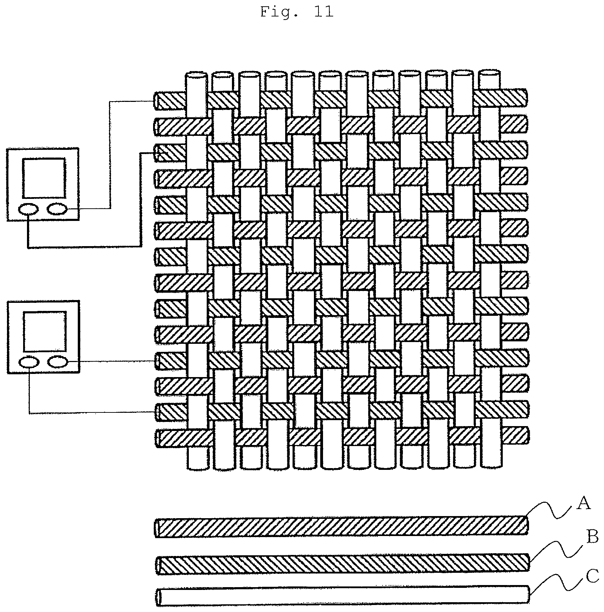

As shown in Fig. 11, a plain woven fabric was manufactured by arranging the insulating fibers 1 as a warp and the piezoelectric fibers 1 and the conductive fibers 1 alternately as wefts. When a pair of the conductive fibers sandwiching the piezoelectric fiber close to both ends of this woven fabric were connected as signal lines to a voltage source and a voltage was applied, the fabric was entirely twisted. It was confirmed that this plain woven fabric functioned as a piezoelectric element (actuator). As a result of durability evaluation, even after 2,000 folding tests, this function was obtained.

### Example 6

As shown in Fig. 12, a satin woven fabric was manufactured by arranging the insulating fibers 1 as a warp and the insulating fibers 1, the conductive fibers 1, the piezoelectric fibers 1 and the conductive fibers 1 in this order as wefts. When a pair of the conductive fibers sandwiching the piezoelectric fiber of this woven fabric were connected as signal lines to an oscilloscope and the fabric was twisted, about 0.01 V voltage signal was obtained. It was confirmed that this satin woven fabric functioned as a piezoelectric element (sensor). As a result of durability evaluation, even after 2, 000 folding tests, piezoelectricity was kept at not less than 90 %.

### Example 7

Four braids were manufactured by using a copper deposited aramid fiber manufactured by Teijin Limited as a core and the multifilament uniaxially drawn yarn 1 manufactured in Example 3 as a braided cord.

The four braids were welded together by dissolving the outer surfaces of the fibers of the multifilament uniaxially drawn yarns with dichloromethane to obtain a piezoelectric element.

The piezoelectric characteristics of this piezoelectric element were evaluated with constitution shown in Fig. 14. It was found that a large voltage of 5 V was obtained by rubbing the surface of this piezoelectric element, and it was confirmed that this piezoelectric element functioned as a sensor. As a result of durability evaluation, even after 2,000 folding tests, piezoelectricity was kept at not less than 90 %.

### Example 8

### (production of polylactic acid)

0.005 part by weight of tin octylate was added to 100 parts by weight of L-lactide (manufactured by Musashino Chemical Laboratory, Ltd., optical purity of 100 %) to carry out a reaction in a nitrogen atmosphere at 180°C for 2 hours in a reactor equipped with a stirring blade, phosphoric acid was added in an amount which was 1.2 times the equivalent of tin octylate, the residual lactide was removed under a reduced pressure of 13.3 Pa, and the resulting product was formed into a chip to obtain poly-L-lactic acid (PLLA1). The obtained PLLA1 had a weight average molecular weight of 152, 000, a glass transition point (Tg) of 55°C and a melting point of 175°C.

### (evaluation of piezoelectric element)

The piezoelectric element was evaluated as follows in Example 8.

Piezoelectric characteristics were evaluated by contacting a finger to the surface of the surface conductive layer (gold deposited surface) and rubbing it with the finger in a direction parallel to the longitudinal direction of the piezoelectric element at a rate of about 0.5 m/s (the load was set substantially to the same level of not more than 50 gf (500 mmN) in all Examples and Comparative Examples). The evaluation system of this Example is shown in Fig. 14. The DL6000 series digital oscilloscope (trade name of DL6000) of Yokokawa Electric Corporation was used for voltage evaluation to measure its detection voltage.

### (evaluation of durability)

Each of the piezoelectric elements was folded in a direction perpendicular to the conductive fibers. This was repeated 2, 000 times continuously to carry out the evaluation of the piezoelectric element again.

### (production of piezoelectric element)

A copper deposited aramid fiber manufactured by Teijin Limited was used as a conductive fiber, covered concentrically with PLLA1 molten at a resin temperature of 200°C and cooled in air immediately to obtain a covered fiber 1 having a length of 10 m.

The copper deposited aramid fiber in the covered fiber 1 is the conductive fiber in the present invention and had a volume resistivity of 1.0 x 10⁻² Ω·cm. The diameter of the conductive fiber was 0.6 mm, and the thickness of the covered PLLA1 layer was 0.3 mm (diameter of the covered fiber 1 was 1.2 mm).

Then, this covered fiber 1 was cut to a length of 12 cm, and a 1 cm part was removed from both ends of only the inner conducive fiber to manufacture a covered fiber 2 including the inner conductive fiber having a length of 10 cm and the outer PLLA1 layer having a length of 12 cm. Thereafter, this covered fiber 2 was put into a tensile tester set at 80°C, both end parts (1 cm end parts) composed of only the PLLA1 layer of the covered fiber 2 were held by a nip, and only the outer PLLA1 layer was uniaxially drawn. The drawing speed was 200 mm/min, and the draw ratio was 3 times. Thereafter, while these parts were held by the nip, the temperature was raised up to 140 °C to heat the covered fiber 2 for 5 minutes which was then crystallized, quenched and taken out from the tensile tester.

The obtained covered fiber 2 had two layers which were concentric to each other and a diameter of 0.8 mm, and the thickness of the covered PLLA1 layer was 0.1 mm. Further, about half of the surface of this covered fiber was coated with gold to a thickness of about 100 nm by vapor deposition to obtain the piezoelectric element of the present invention. This gold surface conductive layer had a volume resistivity of 1.0 x 10⁻⁴ Ω·cm.

A schematic diagram of this piezoelectric element is shown in Fig. 13. Four of the piezoelectric elements were manufactured by the same method and arranged parallel to one another as shown in Fig. 14 to carry out the evaluation of piezoelectric characteristics.

As a result of the evaluation of the piezoelectric elements, it was found that a very large voltage of not less than 3 V was obtained simply by rubbing the surfaces. It was confirmed that the piezoelectric elements functioned as a sensor. As a result of durability evaluation, even after 2,000 folding tests, piezoelectricity was kept at not less than 90 %.

### Example 9

### (production of polylactic acid)

0.005 part by weight of tin octylate was added to 100 parts by weight of L-lactide (manufactured by Musashino Chemical Laboratory, Ltd., optical purity of 100 %) to carry out a reaction in a nitrogen atmosphere at 180°C for 2 hours in a reactor equipped with a stirring blade, phosphoric acid was added in an amount which was 1.2 times the equivalent of tin octylate, the residual lactide was removed under a reduced pressure of 13.3 Pa, and the resulting product was formed into a chip to obtain poly-L-lactic acid (PLLA1). The obtained PLLA1 had a weight average molecular weight of 152, 000, a glass transition point (Tg) of 55°C and a melting point of 175°C.

### (evaluation of piezoelectric element)

The piezoelectric element was evaluated as follows in Example 9.

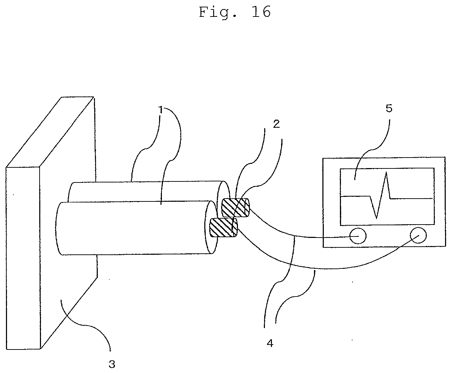

Piezoelectric characteristics were evaluated by contacting a finger to the surface of the piezoelectric element and rubbing it with the finger in a direction parallel to the longitudinal direction of the piezoelectric element at a rate of about 0.5 m/s. The evaluation system of Example 9 is shown in Fig. 16. The DL6000 series digital oscilloscope (trade name of DL6000) of Yokokawa Electric Corporation was used for voltage evaluation.

### (production of piezoelectric element)

A copper deposited aramid fiber manufactured by Teij in Limited was used as a conductive fiber, covered concentrically with PLLA1 molten at a resin temperature of 200°C and cooled in air immediately to obtain a covered fiber 1 having a length of 10 m.

The copper deposited aramid fiber in the covered fiber 1 is the conductive fiber in the present invention and had a volume resistivity of 1.0 x 10⁻² Ω·cm. The diameter of the conductive fiber was 0. 6 mm, and the thickness of the covered PLLA1 layer was 0.3 mm (diameter of the covered fiber 1 was 1.2 mm).

Then, this covered fiber 1 was cut to a length of 12 cm, and a 1 cm part was removed from both ends of only the inner conducive fiber to manufacture a covered fiber 2 including the inner conductive fiber having a length of 10 cm and the outer PLLA1 layer having a length of 12 cm. Thereafter, this covered fiber 2 was put into a tensile tester set at 80 °C, both end parts (1 cm end parts) composed of only the PLLA1 layer of the covered fiber 2 were held by a nip, and only the outer PLLA1 layer was uniaxially drawn. The drawing speed was 200 mm/min, and the draw ratio was 3 times. Thereafter, while these parts were held by the nip, the temperature was raised up to 140°C to heat the covered fiber 2 for 5 minutes which was then crystallized, quenched and taken out from the tensile tester.

The obtained covered fiber 2 had two layers which were concentric to each other and a diameter of 0.9 mm, and the thickness of the PLLA1 layer was 0.15 mm. Further, two of the covered fibers 2 were welded together, end parts of the piezoelectric polymer on the surfaces were removed, and the conductive fibers were exposed to obtain a piezoelectric element shown in Fig. 15.

The piezoelectric characteristics of this piezoelectric element were evaluated with constitution shown in Fig. 16. As a result of the evaluation of the piezoelectric element, it was found that a very large voltage of about 6 V was obtained simply by rubbing the surface. It was confirmed that the piezoelectric element functioned as a sensor. As a result of durability evaluation, even after 2,000 folding tests, piezoelectricity was kept at not less than 90 %.

### Effect of the Invention

### (transducer outputting an electric signal)

The transducer outputting an electric signal of the present invention can be manufactured by adopting a conventional woven or knitted structure using ordinary fiber materials. The transducer can be made in the form of cloth having flexibility. The transducer can be made in any form such as cloth which can be folded like a handkerchief or clothing. The transducer may be used as a cloth sensor or cloth power generating element.

### (transducer inputting an electric signal)

The transducer inputting an electric signal of the present invention can be manufactured by adopting a conventional woven or knitted structure using ordinary fiber materials. The transducer can be made in the form of cloth having flexibility. The transducer can be made in any form such as cloth which can be folded like a handkerchief or clothing. Since the transducer changes its form when an electric signal is applied thereto, it may be used as an actuator.

### Industrial Applicability

### (transducer outputting an electric signal)

The transducer outputting an electric signal of the present invention may be used as a cloth sensor or cloth power generating element.

Examples of the sensor include touch panels, surface pressure-sensitive sensors for humans and animals, and sensors for detecting the bending, twisting and expansion/contraction of a joint in the form of clothing such as a hat, glove or sock, a supporter or a handkerchief.

For example, when it is used for humans, it may be used as a sensor which detects contact or movement and collects information on the movement of a joint for medical applications. Further, it may be used for amusement applications and as an interface for moving a lost part or a robot. In addition, it may be used as a surface pressure-sensitive sensor for stuffed toys and robots which imitate animals and humans, or a sensor for detecting the bending, twisting and expansion/contraction of a joint.

Further, it may be used as a surface pressure-sensitive sensor or form change sensor for bedclothing such as sheets and pillows, shoe soles, gloves, chairs, carpets, bags and flags.

Still further, since the sensor of the present invention is in the form of cloth, it has stretchability and flexibility and therefore may be used as a surface pressure-sensitive sensor or form change sensor by attaching to or covering all or part of the surface of any structure.

Since the transducer of the present invention can extract an electric signal as an output, it may be used as a power generating element as this electric signal is used as a power source for moving another device or for power storage. Examples of the power generating element include power generating elements for generating power by using in a movable part which moves at its own will, such as a human, animal, robot or machine, power generating elements for generating power on the surface of a shoe sole, carpet or structure which receives pressure from outside, and power generating elements for generating power by a form change in a fluid. Since it produces an electric signal by its form change in a fluid, it can control the adsorption or adhesion of a charged substance in a fluid.

### (transducer inputting an electric signal)

Since the transducer inputting an electric signal of the present invention changes its form when an electric signal is applied thereto, it may also be used as an actuator.

For example, by applying an electric signal to a transducer in the form of cloth, the transducer can move, wrap, compress or vibrate an object mounted on the surface of the cloth.

By controlling an electric signal to be applied to each piezoelectric element constituting the transducer, various forms can be made. Further, it can function as a speaker due to the vibration of the cloth itself.

As a specific example, it may be used as an actuator shaped like clothing such as a hat, glove or sock, a supporter or a handkerchief, which applies pressure to the surface of a human, animal or object. It may also be used as an actuator which supports the bending, twisting and expansion/contraction of a joint. For example, when it is used for a human, it may be used for amusement applications in which contact, movement or pressure is applied and can move a lost part. Further, it may also be used as an actuator which swells or stretches the surface of a stuffed toy or robot which imitates an animal or human, or as an actuator which provides movement such as bending, twisting or expansion/contract to a joint.

Still further, it may be used as an actuator which moves the surface of bedclothing such as sheet or pillow, shoe sole, glove, chair, carpet, bag or flag, or as an actuator in various forms such as handkerchief, wrapping cloth, bag and cloth, which changes its form by an electric signal.

Since the transducer of the present invention is in the form of cloth, it has stretchability and flexibility and therefore may be used as an actuator which changes a surface shape by attaching to or covering all or part of the surface of any structure.

Since the transducer of the present invention can move with an electric signal as an input, it may be used as a speaker which generates sound by its vibration.

## Claims

1. A transducer comprising piezoelectric units, each comprising two conductive fibers and one piezoelectric fiber all of which are arranged substantially on the same plane in the order of the conductive fiber, the piezoelectric fiber and the conductive fiber, and outputting and inputting an electric signal.

2. The transducer according to claim 1, wherein the piezoelectric unit comprises an insulating fiber which is arranged to ensure that the conductive fibers in the piezoelectric unit do not come into contact with the conductive fibers or the conductive fibers and the piezoelectric fiber of another piezoelectric unit.

3. The transducer according to claim 1, wherein the piezoelectric fiber comprises polylactic acid as the main component.

4. The transducer according to claim 1, wherein the piezoelectric fiber comprises poly-L-lactic acid or poly-D-lactic acid as the main component, and the optical purities of these are not less than 99 %.

5. The transducer according to claim 1, wherein the piezoelectric fiber is uniaxially oriented and contains a crystal.

6. The transducer according to claim 1, wherein the conductive fiber is a fiber obtained by coating (i) a carbon fiber or (ii) a synthetic fiber with an electric conductor.

7. The transducer according to claim 1 which has a detection voltage after folded 2,000 times repeatedly in a normal direction to the conductive fiber of not less than 90 % of that before folding.

8. The transducer according to claim 1 which is a woven or knitted fabric comprising a plurality of piezoelectric units.

9. The transducer according to claim 8 which is a woven fabric comprising a plurality of piezoelectric units and whose weave texture is plain weave, twill weave, satin weave or composite texture thereof.

10. The transducer according to claim 8 which is a combination of at least two fabrics selected from the group consisting of knitted fabrics and woven fabrics.

11. A sensor comprising the transducer of any one of claims 1 to 10.

12. A power generating element comprising the transducer of any one of claims 1 to 10.

13. An actuator comprising the transducer of any one of claims 1 to 10.

14. A speaker comprising the transducer of any one of claims 1 to 10.
